# EUROPÄISCHE PATENTSCHRIFT

(11) **EP 1 342 264 B1**
(45) Veröffentlichungstag und Bekanntmachung des Hinweises auf die Patenterteilung: **08.10.2008**
(21) Anmeldenummer: 01985370.4
(22) Anmeldetag: 06.12.2001
(51) Int. Cl.: H01L 21/8238, H01L 27/092

(54) **SCHICHTEN IN SUBSTRATSCHEIBEN**
LAYERS IN SUBSTRATE WAFERS
COUCHES DANS DES PLAQUETTES-SUBSTRATS

(30) Priorität: 08.12.2000 DE 10061191
(43) Veröffentlichungstag der Anmeldung: 10.09.2003
(73) Patentinhaber: IHP GmbH-Innovations for High Performance Microelectronics/Institut für innovative Mikroelektronik, 15236 Frankfurt an der Oder (DE)
(72) Erfinder: HEINEMANN, Bernd, 15234 Frankfurt (Oder) (DE); EHWALD, Karl-Ernst, 15234 Frankfurt (Oder) (DE); KNOLL, Dieter, 15230 Frankfurt (Oder) (DE); TILLAK, Bernd, 15234 Frankfurt (Oder) (DE); WOLANSKY, Dirk, 15234 Frankfurt (Oder) (DE); SCHLEY, Peter, 15234 Frankfurt (Oder) (DE)
(74) Vertreter: Eckey, Ludger
(86) Internationale Anmeldenummer: PCT/EP2001/014318
(87) Internationale Veröffentlichungsnummer: WO 2002/047113

(56) Entgegenhaltungen:
- EP-A- 0 253 059
- WO-A-98/26456
- US-A- 5 578 507
- US-A- 6 153 920
- TSUKAMOTO K ET AL: "High-energy ion implantation for ULSI" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, Bd. B59/60, 1. Juli 1991 (1991-07-01), Seiten 584-591, XP002080680 ISSN: 0168-583X
- FREY L ET AL: "Deep implants for semiconductor device applications" RADIATION EFFECTS AND DEFECTS IN SOLIDS, 1996, GORDON & BREACH, SWITZERLAND, Bd. 140, Nr. 1, Seiten 87-101, XP008004021 ISSN: 1042-0150

## Beschreibung

Die Erfindung bezieht sich auf Schichten in Substratscheiben nach dem Oberbegriff des Anspruchs 1.

Vorteile im Leistungsverbrauch, in der Signalverarbeitungsgeschwindigkeit und den Fertigungskosten sind gegenüber bisher bekannten Multi-Chip-Lösungen zu erwarten, wenn z. B. hochintegrierte Prozessor-Schaltungen (digitale Schaltungstechnik) mit Hochfrequenzschaltungen für Sende- und Empfangsbausteine (analoge Schaltungstechnik) auf einem Chip integriert werden können.

Eine derartige Vereinigung verschiedener Schaltungskomponenten digitaler und analoger Art auf einem Chip stellt hohe Anforderungen an Technologen, Bauelemente-Ingenieure und Schaltungs-Entwickler. Dies resultiert aus dem Umstand, dass den einzelnen Technologieprozessen und Bauelementekonstruktionen zum Teil gegensätzliche oder schwer vereinbare Optimierungskriterien zugrunde liegen und außerdem der gemeinsame Betrieb der Schaltungen auf einem Chip unerwünschte Wechselwirkungen hervorbringen kann.

Für die Herstellung von stark skalierten Digitalschaltungen werden typischerweise hochdotierte p⁺-Substratscheiben mit p⁻-dotierter Epischicht verwendet, um eine ausreichende Sicherheit gegen das Auftreten von Latch-up, das für die Schaltungsfunktion schädliche, thyristorähnliche Zünden einer Vierschichtanordnung, wie sie z. B. bei CMOS-Invertem auftritt, zu gewährleisten.

Für Hochfrequenzschaltungen ist dagegen der Einsatz von möglichst hochohmigen Substratscheiben vorteilhaft, um kapazitiv oder induktiv in das Substrat eingekoppelte Ströme klein zu halten, da diese zu einem erhöhten Leistungsverbrauch, zu einer Güteminderung bei Spulen oder zu einem sogenannten Substratrauschen führen. Zugleich wird der Einfluss von Störsignalen, beispielsweise von den digitalen Schaltungen, auf empfindliche Analogschaltungen reduziert.

Es existieren verschiedene Ansätze, um bei der Vereinigung von digitalen und analogen Hochfrequenz-Schaltungen auf einem Chip die verschiedenen Forderungen an die Substrateigenschaften gleichzeitig zu erfüllen. So werden bei A. Monroy et al., BCTM 1999, 7.3, mit Hilfe einer Implantationsmaske strukturierte und per Epitaxie vergrabene n⁺- und p⁺-Gebiete auf p⁻-Substrat hergestellt, um sowohl Latch-up-Festigkeit durch hochdotierte Wannengebiete als auch geringe Hochfrequenzverluste durch hochohmiges Substrat zu sichern. Dieser Weg verursacht jedoch sowohl zusätzliche Kosten durch zusätzliche Prozessschritte Strukturierung, Wannen-Herstellung und Epitaxie als auch Einschränkungen im Entwurf minimaler n- und p-Wannen-Geblete. Diese Einschränkungen resultieren aus der lateralen Verschiebung der vergrabenen n⁺ (p⁺)Gebiete gegenüber den n- und p-Wannen der CMOS-Technologie aufgrund von Maskendejustage bzw. wegen der lateralen Ausbreitung der vergrabenen n⁺(p⁺)-Gebiete während der Tiefendiffusion.

Der Vorschlag von M. R. Frei et al., IEDM 1999, p. 757, bei dem anstelle des p⁺-Substrates eine vergrabene p⁺-Schicht epitaktisch eingebracht wird, umgeht zwar die zuvor genannten Schwierigkeiten, enthält aber unbefriedigende Kompromisse bezüglich der Latch-up-Festigkeit bzw. der Hochfrequenz-Substratverluste. Diese Kompromisse folgen hinsichtlich der Latch-up-Festigkeit aus dem gegenüber p⁺-Substrat wesentlich erhöhten Substratwiderstand und hinsichtlich der Hochfrequenz-Substratverluste aus dem deutlich kleineren Substratwiderstand und größeren Kapazitäten zwischen n-Wannen und Substrat im Vergleich zu einem p⁻-Substrat.

Um ohne p⁺-Substrat oder ohne hochleitfähige, epitaktisch vergrabene n⁺/p⁺-Schichten die Latch-up-Festigkeit wirksam zu erhöhen, ist es notwendig, die Leitfähigkeit der n- und p-Wannen zu verbessern.

In R. Mahnkopf et al., JEDM 1999, p. 849, wird berichtet, dass im dort beschriebenen Fall auch bei Verzicht auf ein p⁺-Substrat Latch-up ausreichend unterdrückt werden kann, wenn ein zusätzlicher markierter Bor-Implant verwendet wird. Die dort beschriebene Anordnung enthält jedoch keinen Lösungsvorschlag für die Aufgabe, Störsignale von nMOS-Transistoren mittels geeigneter Dotierungsprofile abzuschirmen, wie dies bei A. Monroy et al., BCTM 1999, 7.3, durch epitaktisch vergrabene n⁺-Gebiete, die seitlich über einen Kollektorschacht kontaktiert sind, erreicht wird. Um Prozessaufwand zu sparen und die bei p⁺-Substrat erreichte Skalierung von hochintegrierten CMOS-Schaltungen nicht zu verlieren, wäre eine Herstellung dieses Transistoraufbaus per Implantation von Vorteil.

Anzustreben sind dabei vergrabene Dotantenprofile mit möglichst hoher Dosis und Steilheit. In Bezug auf geeignete Implantationsdosen für sogenannte retrograde Wannen sind verschiedene Kriterien zu beachten, da wegen Latch-up-Festigkeit möglichst niedrige Schichtwiderstände benötigt werden, aber zur Oberfläche ausreichend niedrige Konzentrationen erforderlich sind, um kleine Source-Drain-Kapazitäten zu gewährleisten und die Schwellspannung der MOS-Transistoren unabhängig von der retrograden Wannendotierung einstellen zu können. Außerdem wird der mögliche Dosisbereich nach dem bisher bekannten Stand der Technik eingeschränkt, siehe z. B. K. K. Bourdelle, J. Appl. Phys. Vol. 86, p. 1221, 1999, da in Abhängigkeit von der Jonenart in einem bestimmten Dosisbereich der für die Herstellung retrograder Wannen bevorzugt von Interesse ist, Implantationsschaden nicht defektfrei ausgeheilt werden können.

H.-J. Gossmann et al., IEDM 1998, p. 725, erzeugen eine vergrabene Kohlenstoffschicht per Implantation, um den reversen "Kurzkanal-Effekt" bei MOS-Transistoren abzuschwächen. Für die zu diesem Zweck erforderlichen Kohlenstoffdosen zeigt sich aber, dass trotz Positionierung des Maximums des Implantationsprofils in tieferen, nicht an beweglichen Ladungsträgern verarmten Zonen die Source/Drain-Dioden deutlich erhöhte Leckströme zeigen, wodurch der Einsatz in hochintegrierten Schaltungen in Frage gestellt wird.

Bogen et al., Proceedings of the 11. International Conference on Ion Implantation Technology, 1996, p. 792, beabsichtigen, die mittels Hochenergie-Implantation hergestellten vergrabenen Kohlenstoffschichten für eine Reduktion der Lebensdauer und damit der Diffusionslänge von Minoritätsträgem und schließlich für die Erhöhung der Latch-up-Festigkeit zu nutzen. Wegen der zu großen Tiefe der eingebrachten Schicht (>3 µm) würde aber im Falle des typischen Strompfades beim Latch-up-Auslösen die angestrebte Wirkung ausbleiben, wenn nicht, wie auch bei Gossmann et al. IEDM 1998, p. 725, festgestellt, in den Regionen oberhalb der vergrabenen Kohlenstoffschicht die Lebensdauern nennenswert abgesenkt wären. Diese Reduktion ist jedoch unbedingt zu vermeiden, da in den Raumladungszonen zwischen Source-Drain-Gebieten und Wannen, aber auch am Übergang n-Wanne/p-Substrat geringe Leckströme erforderlich sind. Die bisher vorgestellten Varianten zeigen keinen Weg, diese Forderung zu erfüllen.

Tsukamoto et al. beschreiben p⁻- Siliziumsubstratscheibe mit Source- und Drain-Gebieten für MOS-Transistoren in der Silizium-Cap-Schicht, einer p-Wanne und einer n-Wanne, sowie einer vergrabenen "Gettering"-Schicht, die hoch p-leitfähig ist, also eine p⁺-Schicht bildet. Die Getteringschicht enthält zusätzlich zur Leitfähigkeitsdotierung Sauerstoff, Kohlenstoff oder Fluor. Die Getteringschicht dient zur Reduzierung der Defektdichte und damit des Leckstroms in einem MOS-Bauelement mit einem n⁺/p-Übergang oberhalb der vergrabenen Gettering-Schicht.

EP 0 253 059 A2 beschreibt ein Verfahren zum Unterdrücken des Aufsteigens einer vergrabenen Schicht in einem Halbleiterbauelement. Dort eine Unterdrückung einer Dotandendiffusion durch Kohlenstoff-Coimplantation in die dotierten Schichten beschrieben.

Aufgabe der Erfindung ist es, Schichten in Substratscheiben anzugeben, bei dem die beschriebenen Nachteile konventioneller Anordnungen überwunden werden, um bei vergleichsweise geringen Kosten auf der einen Seite eine ausreichende Latch-up-Festigkeit in stark skalierten, digitalen CMOS-Schaltungen zu erreichen und auf der anderen Seite geringe Substratverluste/-Einkopplungen für analoge Hochfrequenzschaltungen zu sichern und darüber hinaus das Bauelementeverhalten nicht schädlich zu beeinflussen.

Erfindungsgemäß wird diese Aufgabe durch die Merkmale des Anspruchs 1 gelöst. In einem hochohmigen p⁻-Si-Substrat (2) mit einer oder mehreren vergraben kohlenstoffreichen Si-Schichten (3) unter einer epitaktischen Schicht, der Si-Cap-Schicht (4), wobei die Konstruktion der vergrabenen kohlenstoffreichen Si-Schichten so ausgeführt ist, dass die Eigenschaften der Bauelemente nicht schädlich beeinflusst werden, insbesondere die Source/Drain-Leckströme von MOS-Transistoren nicht erhöht werden, wird durch Unterdrückung der Dotantendiffusion und Defektgenerierung beim Ausheilen von Implantschäden eine im Vergleich zu konventionellen Substratscheiben größere Implantationsdosis für retrograde Wannenprofile angewendet und damit eine Reduktion des Wannenwiderstandes und schließlich eine Erhöhung der Latch-up-Festigkeit erreicht, und die bipolaren Wechselwirkungsmechanismen beim Auslösen von Latch-up durch die lokale Reduktion der Ladungsträgerlebensdauer werden behindert. Die Dicke der kohlenstoffreichen Si-Schicht (3) und die der Si-Cap-Schicht (4) sind so ausgeführt, dass weder die Verarmungszone zwischen einer n-Wanne und dem p⁻-Si-Substrat (2) noch die Verarmungszonen zwischen den Source-Drain-Gebieten von MOS-Transistoren und den p- bzw. n-Wannen die kohlenstoffreiche Si-Schicht (3) unter Betriebsbedingungen erreichen. Die Konzentration des Kohlenstoffs liegt in der oder den kohlenstoffreichen Si-Schichten (3,33) zwischen 2x10¹⁸ cm⁻³ und 3x10²⁰ cm⁻³, vorzugsweise zwischen 5x10¹⁸ cm⁻³ und 5x10²⁰ cm⁻³. Nach Ausheilung von Implantationsschäden für Implantationsdosen über 3x10¹³cm⁻² sind geringe Defektdichten in der oberflächennahen Si-Cap-Schicht (4) kleiner 10⁴ cm⁻² vorhanden. Die Art der Einbringung und die Lage dieser Schichten wird so gewählt, dass die Latch-up-Festigkeit in mehrfacher Hinsicht gegenüber konventionellen Lösungen verbessert werden kann. Die lokale Reduktion der Ladungsträgerlebensdauer und damit der Diffusionslänge der Minoritätsladungsträger in der kohlenstoffreichen Si-Schicht behindert die bipolaren Wechselwlrkungsmechanismen beim Auslösen von Latch-up. Des weiteren erlauben die vergrabenen, kohlenstoffreichen Si-Schichten eine Unterdrückung der punktdefektgestützten Erzeugung von Kristallfehlern wahrend Ausheilung von Implantationsschäden. Dadurch kann gegenüber konventionellen, reinen Si-Substraten der Bereich der Implantationsdosen für retrograde Wannenprofile, die in Oberflächennähe ausreichend defektarme Regionen hinterlassen, erweitert werden. Ferner steigt die Freiheit in der Gestaltung der Implantationsprofile für die tiefer gelegenen, höher leitfähigen Schichten der n- und p-Wannen durch die lokale Unterdrückung von TED in der Umgebung der vergrabenen, kohlenstoffreichen Si-Schichten während der Ausheilung von Implantationsschäden.

Die Konstruktion der vergrabenen kohlenstoffreichen Si-Schichten wird dabei so ausgeführt, dass die Eigenschaften der Bauelemente einer gegebenen CMOS- bzw. BiCMOS-Technologie im Wesentlichen nicht beeinflusst, insbesondere die Source/Drain-Leckströme nicht erhöht werden.

Die Zeichnungen zeigen:
- Fig. 1a: Schematische Darstellung mit erfindungsgemäßen Schichten der Substratscheibe (1) mit vergrabener kohlenstoffreicher Si-Schicht (3).
- Fig. 1b: Schematische Darstellung mit erfindungsgemäßen Schichten wie in Fig. 1a außerdem mit Isolationsgebiet (5) sowie p- und n-Wanne (6/7), die im CMOS-Prozeß erzeugt werden.
- Fig. 1c: Schematische Darstellung mit erfindungsgemäßen Schichten wie in Fig. 1b außerdem mit Raumladungszone (8) zwischen n-Wanne (7) und p⁻-Substrat (2) bzw. p-Wanne (6) sowie Raumladungszonen (9) zwischen n⁺- bzw. p⁺-Source/Drain-Gebieten (10,11) und den Wannen (6/7).

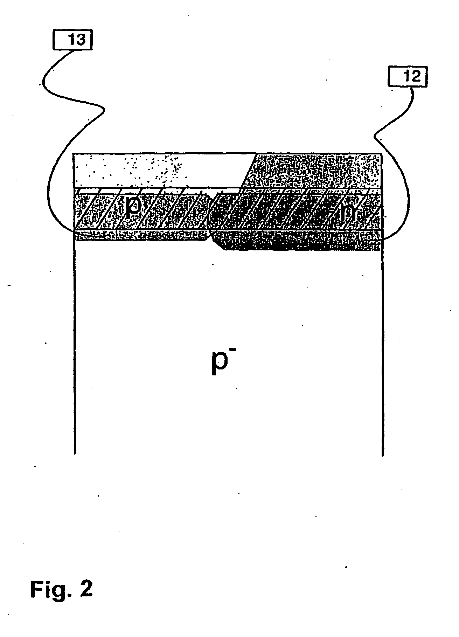

- Fig. 2: Schematische Darstellung mit erfindungsgemäßen Schichten wie in Fig. 1b außerdem mit Zusatzdotierung (12/13) unter der n- und p-Wanne (7/6).
- Fig. 3: Schematische Darstellung der parasitären npn- und pnp-Bipolartransistoranordnung (21/22).

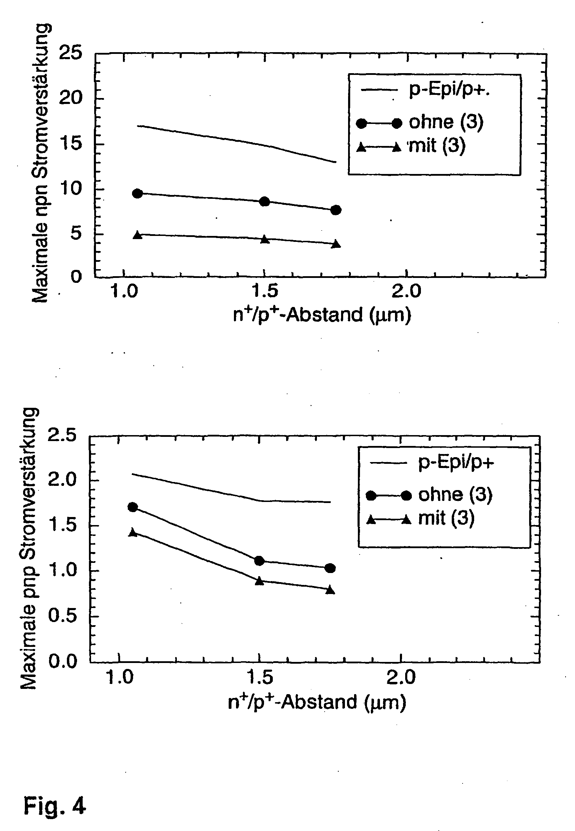

- Fig. 4: Gemessene Stromverstärkungen der parasitären Bipolartransistoranordnungen als Funktion des n⁺/p⁺-Abstandes.
- Fig. 5: Gemessene Leckstrom-Kennlinien der p⁺-Source/Drain-n-Wannen-Diode.
- Fig. 6: Schematische Darstellung mit erfindungsgemäßen Schichten mit zwei vergrabenen kohlenstoffreichen Si-Schichten.
- Fig. 7:: Schichtwiderstand von n- bzw. p-dotierten kohlenstoffreichen Si-Schichten für verschiedene Kohlenstoffkonzentrationen im Vergleich zu gewöhnlichen Si-Scheiben.
- Fig. 8:: Schematische Darstellung erfindungsgemäßer Schichten mit vergrabener kohlenstoffreicher Si-Schicht.

Die Erfindung wird im Zusammenhang mit einem state-of-the-art CMOS-Prozess beschrieben. Es ist verständlich, dass ebenso Modifikationen dieses Prozesses, wie z. B. die Einführung von Prozessmodulen für BiCMOS Technologien möglich sind.

### Beispiel 1:

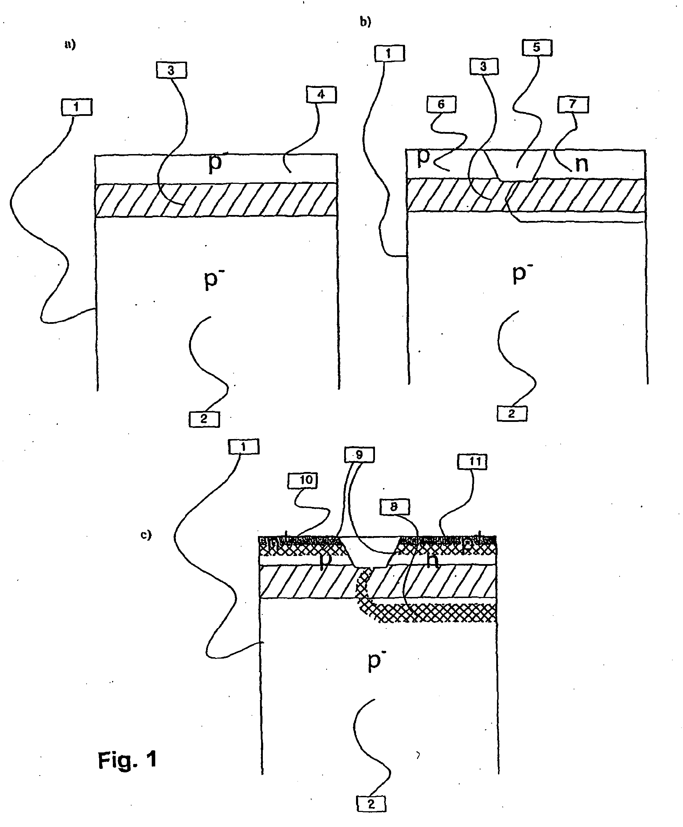

Dieses Ausführungsbeispiel, dargestellt in Figur 1, zeigt schematisch die wesentlichen Details gemäß der Erfindung. In Figur 1a die erfindungsgemäßen Schichten der Substratscheibe (1), bestehend aus p⁻-Substrat (2) und vergrabener kohlenstoffreicher Si-Schicht (3). Außerdem in Figur 1b mit Isolationsgebiet (5) sowie p- und n-Wanne (6/7), die im CMOS-Prozess erzeugt werden und in Figur 1c mit Raumladungszone (8) zwischen n-Wanne (7) und p-Substrat (2) bzw. p-Wannen (6) sowie Raumladungszonen (9) zwischen n⁺- bzw. p⁺-Source/Drain-Gebieten (10,11) und den Wannen (6/7). Die Konzentration des Kohlenstoffs in der kohlenstoffreichen Si-Schicht (3) kann zwischen 2x10¹⁸ cm⁻³ und 3x10²⁰ cm⁻³, vorzugsweise zwischen 5x10¹⁸ cm⁻³ und 5x10¹⁹ cm⁻³ liegen. Über der kohlenstoffreichen Si-Schicht (3) wird epitaktisch, z. B. mit Hilfe von CVD, eine (kohlenstoffarme) Si-Cap-Schicht (4) abgeschieden, die eine geringe Dotantenkonzentration von weniger als 1x10¹⁷ cm⁻³ vorzugsweise unter 1x10¹⁶ cm⁻³ enthält.

### Beispiel 2:

Vor dem eigentlichen CMOS-Prozessablauf wird die Substratscheibe (1) in folgender Weise hergestellt. Auf einer Substratscheibe (1) aus einem möglichst hochohmigen p-Substrat (2) wird epitaktisch mit Hilfe eines Chemical Vapor Deposition (CVD)-Verfahrens eine kohlenstoffreiche Si-Schicht (3), wie in Beispiel 1 charakterisiert, vergraben. Bei der Abscheidung der Si-Cap-Schicht (4) ist sowohl Hochtemperatur (HT)- oder auch Niedrigtemperatur (engl. Low-Temperature LT)-Epitaxie anwendbar. Auf der Substratscheibe (1) werden dann mit dem CMOS-Prozessablauf flache Trenches als Isolationsgebiete (5) zwischen der p-Wanne (6) und der n-Wanne (7) eingebracht. Die Dicke der kohlenstoffreichen Si-Schicht (3) und die der Si-Cap-Schicht (4) sind so zu wählen, dass weder die Verarmungszone (8) zwischen der n-Wanne (7) und dem p⁻-Si-Substrat (2) noch die Verarmungszonen (9) zwischen den Source-Drain-Gebieten von MOS-Transistoren (10) und (11) und den Wannen (6/7) die kohlenstoffreiche Si-Schicht (3) unter Betriebsbedingungen erreichen.

### Beispiel 3:

In Abwandlung zum Herstellungsverfahren aus dem Beispiel 2 ist es auch möglich, eine defektarme einkristalline, kohlenstoffreiche Si-Schicht in der Weise herzustellen, dass Kohlenstoff in hohen Dosen implantiert wird und dass das gestörte Kristallgitter anschließend mit Hilfe von Fest-Phasen-Epitaxie rekonstruiert wird.

### Beispiel 4:

In diesem Ausführungsbeispiel wurde auf einem kommerziell verfügbaren p⁻-Substrat (2) mit einer Leitfähigkeit von 30-60 Qcm eine etwa 300nm dicke kohlenstoffreiche Si-Schicht (3) mit einer Kohlenstoffkonzentration von ungefähr 1x10¹⁹ cm⁻³ sowie eine Si-Cap-Schicht (4) von 500nm mittels LT-CVD-Epitaxie abgeschieden. Die elektrisch aktive Dotantenkonzentration in der kohlenstoffreichen Si-Schicht (3) und in der Si-Cap-Schicht (4) liegt unter 5x10¹⁵ cm⁻³. Nach Herstellung der Substratscheibe (1) wurde ein Hochtemperaturschritt, z. B. bei 1000 °C/1h, auf die Scheibe angewendet. Es wird erreicht, dass die Kohlenstoffverteilung in der kohlenstoffreichen Si-Schicht (3) auch während nachfolgender Temperaturbehandlungen nicht mehr wesentlich verändert wird. Dieser Hochtemperaturschritt kann auch während des nachfolgenden CMOS-Prozesses erfolgen. Im Weiteren wird die erfindungsgemäße Substratanordnung auf Basis eines typischen Dual-Gate-0.25 µm-CMOS-Prozesses mit flacher Trench-Isolation, retrograden p- und n-Wannen, Co-Silizierung und Alu-Metallisierung getestet.

### Beispiel 5:

In Abwandlung zu den Herstellungsverfahren wie in den vorangegangenen Beispielen beschrieben, ist es vorteilhaft, zu den p- und n-Wannen (6,7) eine Zusatzdotierung (12,13) einzubringen, um die Latch-up-Festigkeit zu erhöhen. Die Zusatzdotierung (12) wird vor den Implantationen für die p- und n-Wannen (6,7) eingebracht. Für die Zusatzdotierung (12) ist in diesem Ausführungsbeispiel Phosphor separat per Maske implantiert und ausgeheilt worden. Sie kann wahlweise sowohl unter den p-Wannen zur elektrischen Abschirmung der nMOS-Transistoren als auch unter den n-Wannen zur Verbesserung der Latch-up-Festigkeit verwendet werden. Für diesen Maskenschritt werden die gleichen Entwurfsregeln wie für die n-Wanne (7) benutzt. Außerdem ist mit der Lackmaske für die p-Wanne die Zusatzdotierung (13) für die p-Wanne als zusätzlicher Bor-Implant eingebracht worden. Energie und Dosis dieser Implante (300 keV/2x10¹³ cm⁻² für Bor und 750 keV/5x10¹³ cm⁻² für Phosphor) sind so gewählt, dass sich die schwellspannungsbestimmende Dotierung der oberflächennahen Bereiche nicht verändert.

### Beispiel 6:

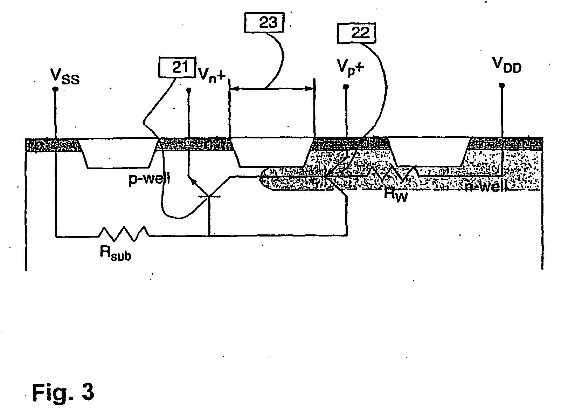

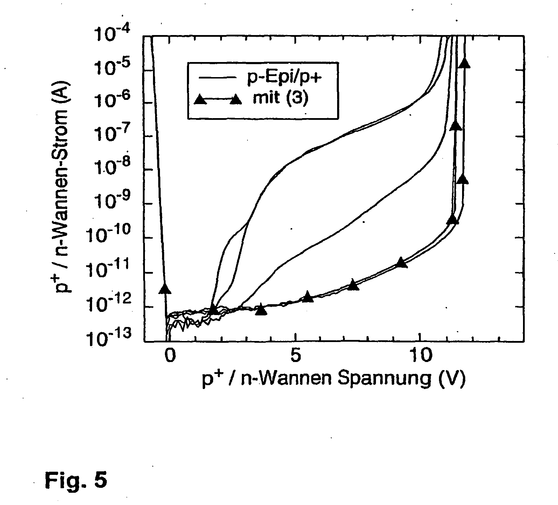

Die Wirkung der kohlenstoffreichen Si-Schicht bezüglich der elektrischen Eigenschaften, insbesondere des Latch-up-Verhaltens, wurde experimentell mit der Anordnung der Schichten, wie in den vorangegangenen Beispielen beschrieben und hergestellt, getestet. Der Einfluss auf das Latch-up-Verhalten wird mit Hilfe der in Figur 3 gezeigten Teststruktur untersucht. Symbolisiert sind die parasitäre npn- (21) und parasitäre pnp-Bipolartransistoranordnung (22) sowie der für das Latch-up-Verhalten charakteristische n⁺-p⁺-Abstand (23). Hervorgerufen durch die höhere Leitfähigkeit, die mit Hilfe der Zusatzdotierung (12,13) erreicht wird und die reduzierte Diffusionslänge der Minoritätsträger in der kohlenstoffreichen Si-Schicht (3) sinkt die Stromverstärkung der parasitären npn- bzw. pnp-Bipolartransistoranordnungen (2 1,22) für die Anordnung mit kohlenstoffreicher Si-Schicht gegenüber der p⁻-Epi/p⁺-Standard-Variante bzw. gegenüber dem Fall p⁻-Substrat mit Zusatzdotierung, aber ohne kohlenstoffreiche Si-Schicht. Figur 5 zeigt anhand der Leckströme zwischen p⁺-Source/Drain und n-Wannen für die Variante mit kohlenstoffreicher Si-Schicht (3) gegenüber den Vergleichsvarianten geringere Defektdichten in der oberflächennahen Si-Cap-Schicht (4) nach der Ausheilung von Implantationsschäden. Das bedeutet, dass für gleiches Leckstromniveau bei Verwendung der kohlenstoffreichen Si-Schicht (3) größere Implantationsdosen für die tiefer gelegenen Teile der Wannenprofile genutzt werden können.

### Beispiel 7:

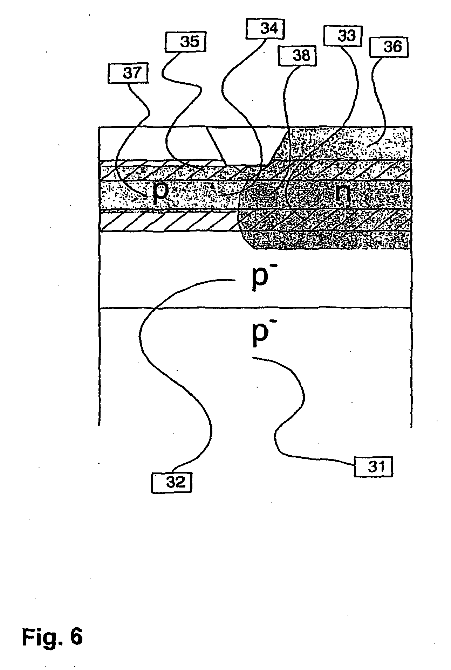

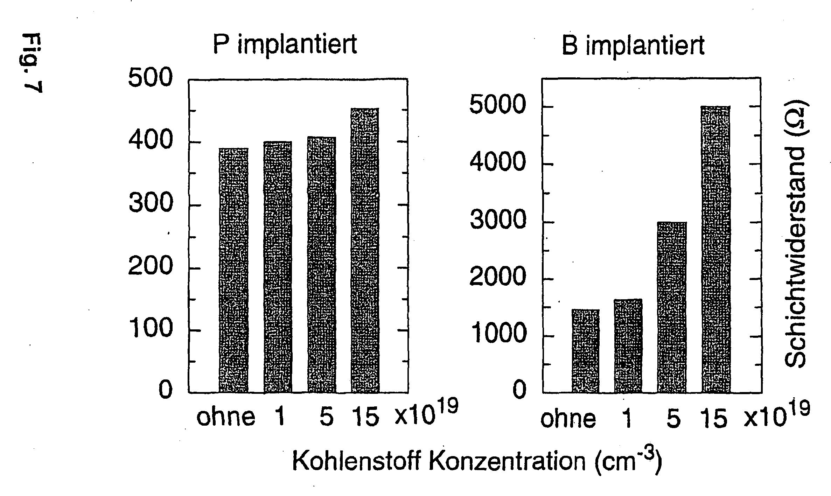

Die in Figur 6 gezeigte Anordnung kombiniert weitere Merkmale der vorliegenden Erfindung. Auf einer p⁻-Substrat (31) von 30-60 Ωcm ist eine p⁻-Si-Pufferschicht (32) abgeschieden worden. Diese Schicht hat die Aufgabe, zwischen der Substrat- (31) und den nachfolgenden Deckschichten eine sauerstoffarme Zone zu schaffen. Die Dicke der p⁻-Si-Pufferschieht (32) kann 0.2 µm bis 10 µm, vorzugsweise 2 µm, betragen. Die Abscheidung ist mit einem üblichen LT- oder HT-CVD-Epitaxie-Prozess, vorzugsweise mit HT-CVD-Epitaxie, ausführbar. Anschließend wird eine erste kohlenstoffreiche Si-Schicht (33) abgeschieden. Zur Herstellung können, wie in Beispiel 1 beschrieben, LT-CVD oder Implantation eingesetzt werden. Die Dicke liegt im Bereich von einigen 10 nm bis 2000 nm, vorzugsweise von 50 nm bis 600 nm. Es ist eine Kohlenstoffkonzentration im Bereich von 5x10¹⁸ cm⁻³ bis 3x10²⁰ cm⁻³, vorzugsweise zwischen 5x10¹⁸ cm⁻³ und 1x10²⁰ cm⁻³, einzustellen. Über der ersten kohlenstoffreichen Si-Schicht (33) wird eine schwachdotierte Si-Zwischenschicht (34) mit Hilfe eines gewöhnlichen CVD-Prozesses erzeugt. Die Dicke kann zwischen 100 nm und 1000 nm, vorzugsweise bei 300 nm bis 600 nm liegen. Es folgt eine zweite kohlenstoffreiche Si-Schicht (35) über der Si-Zwischenschicht (34), deren Kohlenstoffkonzentration kleiner oder ähnlich der Konzentration ist, die bei der ersten kohlenstoffreichen Si-Schicht (33) verwendet wird. Die erfindungsgemäße Substratanordnung wird über der zweiten kohlenstoffreichen Si-Schicht (35) durch eine schwachdotierte, epitaktisch erzeugte Si-Cap-Schicht (36) vervollständigt. Die Dicke kann 100 nm bis 600 nm, vorzugsweise 300 nm bis 500 nm, betragen. Um die Latch-up-Festigkeit gegenüber der Anordnung von Beispiel 1 zu verbessern, sind Energie und Dosis der Bor- bzw. Phosphor-Implantationen für die Zusatzdotierung (37,38) erhöht worden. Der im Vergleich zum CMOS-Standardprozess zusätzliche Bor-Implant für die Zusatzdotierung (37), der gemeinsam mit der p-Wanne eingebracht wird, ist mit einer Energie von 400 keV und einer Dosis von 6x10¹³ cm⁻² erzeugt worden. Die Energie des Phosphor-Implanten für die Zusatzdotierung (38) wird wesentlich durch folgende Forderungen bestimmt: Zum einen wird eine gute Leitfähigkeit der durch den Phosphor-Implanten unter einer p-Wanne entstehenden vergrabenen n-Schicht zwecks elektrischer Abschirmung von nMOS-Transistoren angestrebt. Dafür ist eine ausreichend hohe Implantationsenergie nötig, um eine Kompensation durch die Zusatzdotierung (37) zu vermeiden. Andererseits kann die Zusatzdotierung (38) in die n-Wannengebiete eingebracht werden. Um gleiche Entwurfsregeln für die Zusatzdotierung (38) und für die n-Wanne anwenden zu können, ist die Implantationsenergie nach oben durch die dafür maximal erlaubte Lackdicke beschränkt. Ausgehend von den in diesem Beispiel gewählten Daten für Energie und Dosis der Zusatzdotierung (37) ergibt sich aus den genannten Forderungen für den Phosphor-Implanten ein Energiebereich von 0.9 MeV bis 1.3 MeV. Neben der Forderung nach guter Leitfähigkeit wird der Dosiswert für den Phosphor-Impianten von der Bedingung regiert, dass das elektrische Verhalten der pMOSTransistoren nicht durch eventuelle Profilausläufer an der Oberfläche beeinflusst werden darf. Hieraus resultiert ein geeigneter Dosisbereich von 2x10¹³ cm⁻² bis 5x10¹⁴ cm⁻². Zusätzliche Einschränkungen für die Dosis können sich aus der Forderung nach defektarmer Ausheilung der Implantationsschäden ergeben. Ziel ist dabei, die Leckströme zwischen Source/Drain- und Wannen-Gebieten kleinzuhalten. Um in BiCMOS-Prozessen eine hohe Ausbeute von Bipolartransistoren mit epitaxial hergestellter Basisschicht zu erreichen, ist ebenfalls eine hohe Kristallperfektion nach der Ausheilung erforderlich. Die Lage der ersten kohlenstoffreichen Si-Schicht (33) ist so gewählt, dass die gegenüberstehenden n- und p-Profile der Zusatzdotierung möglichst steil während der nachfolgenden Prozesse bleiben. Außerdem soll diese Schicht die Diffusionslänge von Minoritätsträgern, die aus der n- Wanne ins Substrat injiziert werden, wirksam herabsetzen. Ober eine geeignete Einstellung des Kohlenstoffgehaltes kann des weiteren lokalisiert im p⁻-Gebiet der kohlenstoffreichen Si-Schicht (33) unter der p-Wanne der elektrische Widerstand deutlich vergrößert werden, wahrend die Leitfähigkeit des n-dotierten Teils der kohlenstoffreichen Si-Schicht weitgehend unbeeinflusst bleibt. Dieses Verhalten ist aus der Darstellung des Schichtwiderstandes von n- oder p-dotierten kohlenstoffreichen Si-Schichten mit unterschiedlicher Kohlenstoffkonzentration in Figur 7 ersichtlich. Durch diese Maßnahme wird erreicht, dass der Potentialabfall in der p-Wanne gemindert und dadurch ein Auslösen von Latch up erschwert wird. Die Einführung der Si-Zwischenschicht (34) hat den Vorteil, dass der Hauptteil der Zusatzdotierung (37) der p-Wanne keinen Leitfähigkeitsverlust durch Kohlenstoffeinbau erleidet. Außerdem wird dadurch das an Ladungsträgern verarmte kohlenstoffreiche Gebiet zwischen p- und n-Wanne verkleinert, wodurch Leckströme verringert werden.

Die zweite kohlenstoffreiche Si-Schicht (35) hat die Funktion, einer Verbreiterung der Implantationsprofile der Zusatzdotierung während der nachfolgenden Prozesse entgegenzuwirken. Außerdem rekombinieren in dieser für Latch-up sensiblen Region verstärkt Ladungsträger, wodurch das Auslösen von Latch-up erschwert wird. Doppel und Mehrfachschichten mit unterschiedlichen C-Konzentrationen sind geeignet, um Leitfähigkeitsunterschiede in den kohlenstoffreichen Si-Schichten einzustellen.

### Beispiel 8:

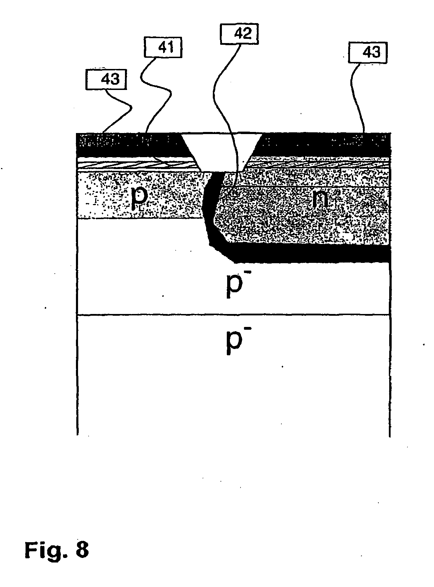

Ein weiteres Ausführungsbeispiel ist in Figur 8 dargestellt. Wie in Beispiel 6 beschrieben, sind auf einer p⁻-Substratscheibe (31) eine p⁻-Si-Pufferschicht (32) und eine kohlenstoffreiche Si-Schicht (41) abgeschieden. Darüber befindet sich die epitaktisch erzeugte Si-Cap-Schicht. Im Unterschied zu den bisher beschriebenen Anordnungen liegt die kohlenstoffreiche Si-Schicht (41) vollkommen oberhalb der Oberkante der Isolationsgebiete. Mit Hilfe dieser Anordnung wird gesichert, dass die Raumladungszone (42) zwischen n-Wanne und p-Substrat keine Überlappung zur kohlenstoffreichen Si-Schicht besitzt und damit Leckströme reduziert werden. Außerdem ist die Dicke der kohlenstoffreichen Si-Schicht so klein zu halten, dass keine Berührung mit den Raumladungszonen (43) zwischen Source/Drain-Gebieten und n- oder p-Wannen eintritt.

## Patentansprüche

1. Hochohmige p⁻-Siliziumsubstratscheibe (1), umfassend
- eine epitaktische Silizium-Cap-Schicht (4) über einem p⁻-Substrat (2);
- Source- und Drain-Gebiete (10, 11) für MOS-Transistoren in der Silizium-Cap-Schicht;
- eine oder mehrere vergrabene epitaktische kohlenstoffreiche Siliziumschichten (3) unter der Silizium-Cap-Schicht, die eine Kohlenstoffkonzentration zwischen 2x10¹⁸ cm⁻³ und 3x10²⁰ cm⁻³ aufweisen, wobei die Silizium-Cap-Schicht und die eine oder mehreren vergrabenen epitaktischen kohlenstoffreichen Siliziumschichten jeweils eine Konzentration elektrisch aktiver Dotanden von weniger als 5x10¹⁵ cm⁻³ enthalten;
- eine oder mehrere p-Wannen (6) und eine oder mehrere n-Wannen (7); wobei die Dicke der kohlenstoffreichen Siliziumschicht (3) und die Dicke der Silizium-Cap-Schicht (4) so ausgeführt sind, dass weder ein Verarmungszonenabschnitt (8), der sich parallel zu einer Oberfläche der hochohmigen p⁻-Siliziumsubstratscheibe zwischen der n-Wanne (7) und dem p⁻-Substrat erstreckt (2), noch Verarmungszonen (9) zwischen den Source- und Drain-Gebieten (10, 11) und den p- und n-Wannen (6, 7) unter Betriebsbedingungen ihre jeweilige Ausdehnung in einer Richtung senkrecht zur Oberfläche der hochohmigen p⁻-Siliziumsubstratscheibe in einem Ausmaß ändern, dass sie die kohlenstoffreiche Siliziumschicht erreichen.

2. Hochohmige p⁻-Siliziumsubstratscheibe nach Anspruch 1, mit einer Silizium-Pufferschicht (32), die zwischen einem darunter liegenden p⁻-Substrat und der kohlenstoffreichen Siliziumschicht eine sauerstoffarme Zone bildet.

3. Hochohmige p⁻-Siliziumsubstratscheibe nach Anspruch 1 oder 2, mit einer vollständig oberhalb einer Unterkante von in der Silizium-Cap-Schicht (43) eingebrachten Isolationsgebieten liegenden kohlenstoffreichen Siliziumschicht (41).

## Claims

1. High-resistance p⁻-silicon substrate wafer (1), comprising
- an epitactic silicon cap layer (4) over a p⁻-substrate (2);
- source and drain regions (10, 11) for MOS transistors in the silicon cap layer;
- one or more buried epitactic carbon-rich silicon layers (3) under the silicon cap layer, which have a carbon concentration of between 2 x 10¹⁸ cm⁻³ and 3 x 10²⁰ cm⁻³,
wherein the silicon cap layer and the one or more buried epitactic carbon-rich silicon layers each contain a concentration of electrically active dopant of less than 5 x 10¹⁵ cm⁻³;
- one or more p-wells (6) and one or more n-wells (7);
the thickness of the carbon-rich silicon layer (3) and the thickness of the silicon cap layer (4) being such that neither a depletion zone portion, which extends parallel to a surface of the high-resistance p⁻-silicon substrate wafer between the n-well (7) and the p⁻-substrate (2), nor depletion zones (9) between the source and drain regions (10, 11) and the p- and n-wells (6, 7) change their respective expansions, under operating conditions, in a direction perpendicular to the surface of the high-resistance p⁻-silicon substrate wafer to such an extent that they reach the carbon-rich silicon layer.

2. High-resistance p⁻-silicon substrate wafer according to claim 1, having a silicon buffer layer (32) which forms an oxygen-impoverished zone between a p⁻-substrate located below it and the carbon-rich silicon layer.

3. High-resistance p⁻-silicon substrate wafer according to claim 1 or 2, having a carbon-rich silicon layer (41) located entirely above a lower edge of insulation regions incorporated in the silicon cap layer (43).

## Revendications

1. Plaquette-substrat de silicium p⁻ (1) de valeur ohmique élevée, comprenant
- une couche d'encapsulation de silicium p⁻ (4) épitaxique par-dessus un substrat p⁻ (2) ;
- des zones source et drain (10, 11) pour transistors MOS dans la couche d'encapsulation de silicium p⁻ ;
- une ou plusieurs couches enfouies de silicium (3) épitaxiques, riches en carbone, sous la couche d'encapsulation de silicium p⁻, qui présentent une concentration de carbone entre 2x10¹⁸ cm⁻³ et 3x10²⁰ cm⁻³, la couche d'encapsulation de silicium et la ou les plusieurs couches enfouies de silicium épitaxiques, riches en carbone, renfermant respectivement une concentration de dopants électriquement actifs de moins de 5x10¹⁵ cm⁻³ ;
- un ou plusieurs puits p (6) et un ou plusieurs puits n (7) ;
plaquette dans laquelle l'épaisseur de la couche de silicium p⁻ (3) riche en carbone et l'épaisseur de la couche d'encapsulation de silicium p⁻ (4) sont réalisées de façon telle, que ni un tronçon de zone d'appauvrissement (8), qui s'étend parallèlement à une surface de la plaquette-substrat de silicium p⁻ de valeur ohmique élevée entre le puits n (7) et le substrat p⁻ (2), ni des zones d'appauvrissement (9) entre les zones source et drain (10, 11) et les puits p et n (6, 7), ne modifient, dans les conditions de fonctionnement, leur étendue respective dans une direction perpendiculaire à la surface de la plaquette-substrat de silicium p⁻ de valeur ohmique élevée, d'une valeur telle qu'ils atteignent la couche de silicium p⁻ riche en carbone.

2. Plaquette-substrat de silicium p⁻ de valeur ohmique élevée, selon la revendication 1, comprenant une couche tampon de silicium (32), qui, entre un substrat p⁻ situé en-dessous et la couche de silicium p⁻ riche en carbone, forme une zone pauvre en oxygène.

3. Plaquette-substrat de silicium p⁻ de valeur ohmique élevée, selon la revendication 1 ou 2, comprenant une couche de silicium p⁻ (41) riche en carbone, entièrement située au-dessus d'un bord inférieur de zones d'isolation réalisées dans la couche d'encapsulation de silicium p⁻ (43).
